Europäisches Patentamt

European Patent Office

Office européen des brevets

(19)

(11) EP 0 915 347 A2

(12) **EUROPÄISCHE PATENTANMELDUNG**

(43) Veröffentlichungstag:
12.05.1999 Patentblatt 1999/19

(51) Int Cl.$^6$: **G01R 27/16**, G01R 27/20

(21) Anmeldenummer: 98890315.9

(22) Anmeldetag: 29.10.1998

(84) Benannte Vertragsstaaten:
AT BE CH CY DE DK ES FI FR GB GR IE IT LI LU MC NL PT SE
Benannte Erstreckungsstaaten:
AL LT LV MK RO SI

(30) Priorität: 04.11.1997 AT 1862/97

(71) Anmelder: Lem Norma GmbH
2351 Wiener Neudorf (AT)

(72) Erfinder: Radda, Peter, Ing.
1110 Wien (AT)

(74) Vertreter: Köhler-Pavlik, Johann, Dipl.-Ing.
Margaretenplatz 5
1050 Wien (AT)

(54) **Verfahren und Vorrichtung zur Messung des Schleifenwiderstandes in Schutzschalter-geschützten Netzen**

(57) Zur Entwicklung eines Verfahrens zur Schleifenwiderstandsmessung in Schutzschaltergeschützten Netzen, welches höhere Stabilität, Genauigkeit und Auflösung als bisherige Meßverfahren aufweist und den Schutzschalter während der Messung nicht auslöst, ist vorgesehen, daß zwischen dem Außenleiter $L_1$, $L_2$, $L_3$ und Schutzleiter PE ein Strom $I_2$ eingeprägt wird, der durch diesen Strom $I_2$ hervorgerufene Spannungsabfall $\Delta U_2$ zwischen Nulleiter N und Schutzleiter PE gemessen wird und daraus der Erdungswiderstand $Z_E$ berechnet wird, und weiters zwischen dem Außenleiter $L_1$, $L_2$, $L_3$ und dem Nulleiter N ein relativ hoher Strom $I_1$ eingeprägt wird, die Spannungsdifferenz $\Delta U_1$ zwischen dem Außenleiter $L_1$, $L_2$, $L_3$ und Schutzleiter PE gemessen wird, daraus der Netzinnenwiderstand $Z_i$ berechnet wird, und der Schleifenwiderstand $Z_s$ aus der Summe des Erdungswiderstandes $Z_E$ und des Netzinnenwiderstandes $Z_i$ ermittelt wird. Die Messung wird nicht wesentlich durch Spannungsstörungen beeinflußt ohne daß der Schutzschalter während der Messung auslöst.

FIG. 2

Printed by Jouve, 75001 PARIS (FR)

(Forts. nächste Seite)

FIG. 3

**Beschreibung**

Die Erfindung betrifft ein Verfahren zur Messung des Schleifenwiderstandes in Schutzschalter-geschützten Netzen nach dem Oberbegriff des Patentanspruchs 1 sowie eine Vorrichtung zur Durchführung dieses Verfahrens nach dem Oberbegriff des Patentanspruchs 4.

Unter dem Begriff Widerstand kann in diesem Zusammenhang sowohl der rein ohm'sche Anteil als auch der komplexe Widerstand, d.h. die Impedanz, welche auch allfällige Scheinwiderstände einschließt, verstanden werden. Der Einfachheit halber wird im folgenden anstelle von Widerstand bzw. Impedanz daher meist nur der Begriff Widerstand verwendet.

Unter die Schutzschalter fallen die üblicherweise eingesetzten Fehlerstromschutzschalter (FI-Schutzschalter), welche bei Abweichung des in einen Verbraucher fließenden Stromes von dem aus dem Verbraucher zurückfließenden Strom über einen bestimmten Nennstrom automatisch unterbrechen, aber theoretisch auch Fehlerspannungsschutzschalter (FU-Schutzschalter).

Der Schleifenwiderstand bzw. die Schleifenimpedanz setzt sich aus dem Netzinnenwiderstand und dem Erdungs- bzw. Ausbreitungswiderstand zusammen. Der Netzinnenwiderstand wird durch den ohm'schen Widerstand der Leitungen, der Streuinduktivität des Netztransformators und dem induktiven Widerstand der Leitungen bestimmt. Man unterscheidet Netze, welche ausschließlich beim Netztransformator geerdet sind (sogenannte T-N-Netze), und solche, welche auch lokal beim Verbraucher geerdet sind (sogenannte T-T-Netze) und Mischformen mit lokaler Erdung eigentlicher T-N-Netze. Je nach Netzform wirken der Widerstand der lokalen Erde bis zur Meßstelle oder der Zuleitungswiderstand des PE(N)-Leiters von der Netzwurzel bis zur Meßstelle oder ein Zusammenwirken beider als tatsächlicher Erdungswiderstand.

Neben der Funktionsprüfung eines Schutzschalters selbst stellt die Bestimmung des Schleifenwiderstands eine der Standardmessungen zur Beurteilung elektrischer Anlagen bzw. elektrischer Installationen dar. Ein korrekter Erdungswiderstand ist Voraussetzung für eine sichere Funktion eines FI- oder FU-Schutzschalters. Nur bei fehlerfreiem Schutzschalter und fehlerfreier Anlage, d.h. korrektem Erdungswiderstand ist die Sicherheit der Personen und Anlagen gewährleistet. Aus diesem Grund ist eine Wiederholungsprüfung des Schleifenwiderstandes und des Erdungswiderstandes vielfach vorgeschrieben. Auch zur Bestimmung des maximalen Kurzschlußstromes ist der Schleifenwiderstand von Bedeutung.

Bekannte Verfahren zur Bestimmung des Erdungswiderstandes erfordern eine Sonde und sind daher unpraktisch und manchmal gar nicht durchführbar. Wird der Nulleiter als Sonde verwendet, so kann es bei T-N-Netzen dazu kommen, daß nicht alle Widerstandsanteile von der Netzwurzel (Sternpunkt) bis zur Meßstelle erfaßt werden.

Üblicherweise erfolgt die Bestimmung des Schleifenwiderstandes durch Belastung der Netzspannung mit einem bekannten Strom und Auswertung des Spannungsunterschiedes zwischen dem unbelasteten und dem belasteten Fall. Beispielsweise beschreibt die EP 0 166 209 A2 ein Meßgerät zur Überprüfung der Schutzmaßnahmen in elektrischen Anlagen, welches auch zur Messung des Schleifenwiderstands nach dem Prinzip der Spannungsabsenkung verwendet werden kann. Mit Hilfe des Meßverfahrens und der Schaltungsanordnung zur Überprüfung von Schutzmaßnahmen in Wechselspannungsnetzen gemäß der EP 0 368 029 A1 kann der Schleifenwiderstand ebenfalls nach der Methode der Spannungsabsenkung ermittelt werden. Da die Netzspannung auch zufälligen Schwankungen, z.B. aufgrund von Schaltvorgängen unterliegt, kommt es in der Regel auch zu Schwankungen des Meßergebnisses, weshalb die Genauigkeit der Messung unzureichend ist. Je kleiner die Meßströme, desto mehr fallen diese zufälligen Schwankungen der Netzspannung ins Gewicht und machen das Meßergebnis unbrauchbar. Beispielsweise liegt der Schleifenwiderstand üblicherweise in der Größenordnung von 1 Ohm, die Schwankungen bei vielen Messungen aber im Bereich von ± 10 Ohm. Verfahren, welche einen höheren Meßstrom anwenden, um eine höhere Genauigkeit zu erreichen, sind für Netze mit vorgeschaltetem Fehlerstromschutzschalter (FI-Schutzschalter) unbrauchbar, da es sonst während der Messung zur Auslösung des Schutzschalters kommen würde.

Es gibt Verfahren, bei denen der Magnetkern des Schutzschalters durch einen Gleichstrom in Sättigung gezwungen wird und dadurch ein ungewolltes Auslösen während der Meßphase verhindert wird. Solche Verfahren haben allerdings den Nachteil, daß bei einer eventuell nachfolgenden Auslöseprüfung das Auslöseverhalten des FI-Schutzschalters verfälscht werden kann. So entsprechen beispielsweise die während einer Prüfung ermittelten Auslösezeiten von FI-Schutzschaltern nicht der Realität.

Aufgabe der Erfindung ist es daher, ein Verfahren zur Messung des Schleifenwiderstandes in Schutzschalter-geschützten Netzen zu entwickeln, welches eine höhere Stabilität, Genauigkeit und Auflösung als bisherige Meßverfahren aufweist und den Schutzschalter während der Messung nicht auslöst.

Gelöst wird die erfindungsgemäße Aufgabe dadurch, daß der durch den zwischen dem oder jedem Außenleiter $L_1$, $L_2$, $L_3$ und dem Schutzleiter PE eingeprägten Strom $I_2$ hervorgerufene Spannungsabfall $\Delta U_2$ zwischen Nulleiter N und Schutzleiter PE, vorzugsweise nach der an sich bekannten Methode der Spannungsabsenkung gemessen wird, daß durch Division des Spannungsabfalls $\Delta U_2$ und des eingeprägten Stromes $I_2$ der Erdungswiderstand $Z_E$ berechnet wird, daß in einem weiteren Schritt zwischen dem oder jedem Außen-

leiter $L_1$, $L_2$, $L_3$ und dem Nulleiter N ein Strom $I_1$ eingeprägt wird, der wesentlich größer als der Auslösestrom des Schutzschalters ist, daß nach dem an sich bekannten Verfahren der Spannungsabsenkung die Spannungsdifferenz $\Delta U_1$ zwischen dem oder jedem Außenleiter $L_1$, $L_2$, $L_3$ und Schutzleiter PE zwischen unbelastetem und durch den zwischen dem oder jedem Außenleiter $L_1$, $L_2$, $L_3$ und dem Nulleiter N eingeprägten Strom $I_1$ belasteten Fall gemessen wird, daß daraus durch Division der Spannungsdifferenz $\Delta U_1$ und des eingeprägten Stromes $I_1$ der Netzinnenwiderstand $Z_i$ berechnet wird, und daß der Schleifenwiderstand $Z_s$ aus der Summe des Erdungswiderstandes $Z_E$ und des Netzinnenwiderstandes $Z_i$ ermittelt wird. In einem Meßschritt des erfindungsgemäßen Verfahrens wird der Erdungswiderstand als eine Komponente des Schleifenwiderstandes gemessen. Durch die Art der Einprägung des Stromes und der Messung der Spannung wirken sich etwaige Störungen der Netzspannung nicht bzw. nur stark reduziert auf das Meßergebnis aus. Daher kann die Messung des Erdungswiderstand trotz eines kleinen Stromes, der den Schutzschalter nicht zur Auslösung bringt, mit guter Genauigkeit erfolgen. Der Strom ist kleiner, vorzugsweise höchstens halb so groß wie der Nennstrom des Schutzschalters. Im anderen Meßschritt kann der Strom theoretisch beliebig hoch gewählt werden, da der Strom zwischen dem oder jedem Außenleiter und dem Nulleiter eingeprägt wird und den Schutzschalter nicht auslöst. Durch diesen relativ großen Strom werden Netzschwankungen besser unterdrückt, sodaß sich diese nicht wesentlich auf das Meßergebnis des Netzinnenwiderstandes auswirken. Obwohl immer vom Erdungswiderstand und vom Netzinnenwiderstand die Rede ist, muß erwähnt werden, daß die durch das erfindungsgemäße Verfahren ermittelten Komponenten des Schleifenwiderstandes nicht mit dem tatsächlichen Erdungswiderstand und dem tatsächlichen Netzinnenwiderstand übereinstimmen müssen. Allerdings resultiert auf alle Fälle ein Verfahren, das den Schleifenwiderstand mit hoher Genauigkeit erfaßt, ohne dabei den Schutzschalter auszulösen. Dieses Verfahren stellt einen wesentlichen Teil der wichtigen Wiederholungsprüfungen von elektrischen Anlagen dar. Die Reihenfolge der Verfahrensschritte zur Bestimmung des Erdungswiderstandes und des Netzinnenwiderstandes als Teile des Schleifenwiderstandes ist dabei beliebig. Die Kombination der beiden Meßschritte resultiert in einer Erhöhung der Stabilität, Genauigkeit und Auflösung der Meßergebnisse. Im Gegensatz zu bekannten Meßverfahren, welche lediglich den oder die Außenleiter und den Schutzleiter während der Messung des Schleifenwiderstandes verwenden, wird bei dem vorliegenden erfindungsgemäßen Verfahren auch der Nulleiter zur Messung herangezogen.

Gemäß einem weiteren Erfindungsmerkmal ist vorgesehen, daß das Netz durch einen zwischen dem oder jeden Außenleiter $L_1$, $L_2$, $L_3$ und dem Nulleiter N angeordneten Widerstand belastet und der resultierende Strom $I_1$ gemessen wird. Auf diese Weise kann das Netz auch ohne Stromquelle belastet werden.

Das Netz kann gemäß einem weiteren Erfindungsmerkmal durch den zwischen dem oder jeden Außenleiter $L_1$, $L_2$, $L_3$ und dem Schutzleiter PE eingeprägten Strom $I_1$ und/oder dem oder jeden Außenleiter $L_1$, $L_2$, $L_3$ und dem Nulleiter N eingeprägten Strom $I_2$ pulsförmig, halbwellenartig oder periodenweise belastet werden. Die Spannungsdifferenz zwischen dem unbelasteten und dem durch die Ströme $I_1$ bzw. $I_2$ belasteten Fall wird in einem oder mehreren aufeinanderfolgenden oder abwechselnden Meßschritten mit pulsförmiger, halbwellenartiger oder periodenförmiger Belastung ermittelt. Die Differenzbildung kann beispielsweise in einem Integrator geschehen, der durch geeignetes Umpolen des Integrators oder der Eingangsspannung die gewünschte Spannungsdifferenz liefert.

Eine weitere Aufgabe der Erfindung besteht in der Schaffung einer Vorrichtung zur Ausführung der oben beschriebenen Verfahren zur Messung des Schleifenwiderstandes in einer möglichst einfachen und raschen Weise.

Gelöst wird diese zweite erfindungsgemäße Aufgabe durch eine Meßvorrichtung mit mindestens drei Anschlüssen zur Verbindung mit den Leitern $L_1$, $L_2$, $L_3$, N, PE des zu analysierenden Netzes, einer Steuerung zur Steuerung des Meßablaufs, welche beispielsweise durch einen Mikrokontroller oder Mikroprozessor gebildet ist, zumindest einer Stromquelle, allenfalls einer Strommeßvorrichtung, zumindest einer Spannungsmeßvorrichtung, zumindest einer Anzeige und allenfalls Bedienungselementen, wobei die oder jede Stromquelle, die oder jede allfällige Strommeßvorrichtung, die oder jede Spannungsmeßvorrichtung, die oder jede Anzeige und die allfälligen Bedienungselemente mit der Steuerung verbunden sind und welche Meßvorrichtung dadurch gekennzeichnet ist, daß mit der oder den Stromquelle(n) ein Strom $I_2$ zwischen dem oder jedem Außenleiter $L_1$, $L_2$, $L_3$ und dem Schutzleiter PE einprägbar und mit der oder den Spannungsmeßvorrichtung(en) der resultierende Spannungsabfall $\Delta U_2$ zwischen Nulleiter N und Schutzleiter PE erfaßbar ist, und daß mit der oder den Stromquelle(n) ein Strom $I_1$ zwischen dem oder jedem Außenleiter $L_1$, $L_2$, $L_3$ und dem Nulleiter N einprägbar und mit der oder den Spannungsmeßvorrichtung(en) der resultierende Spannungsabfall $\Delta U_1$ zwischen dem oder jedem Außenleiter $L_1$, $L_2$, $L_3$ und dem Schutzleiter PE erfaßbar ist, und daß die resultierenden Meßwerte an der oder den Anzeige(n) darstellbar sind. Eine derart aufgebaute Meßvorrichtung gestattet die Durchführung der Messung des Schleifenwiderstandes gemäß der erfindungsgemäßen Verfahren in einer einfachen, raschen und sicheren Art und Weise. Darüber hinaus kann die Vorrichtung so ausgelegt sein, daß sie noch mehr im Zuge der Prüfung von Schutzschaltern gewünschte Verfahren durchführt. Durch die Verwendung eines Mikrokontrollers oder Mikroprozessors als Steuerung kann der Meßablauf vorprogrammiert werden und eine Änderung des Ablaufs durch entsprechende Programmänderung leicht erfolgen. Darüber hinaus verfügen übliche Mikrokontroller oder Mikroprozessoren über interne oder externe Speicherelemente, die zum Speichern von Meßergebnissen oder Zwischenergebnissen eingesetzt werden können. Der Meßvorgang selbst muß nur mehr durch Knopfdruck eingeleitet werden und der Erdungswiderstand und/oder Schleifenwiderstand bzw. allfällige zusätzliche Parameter werden auf der Anzeige dargestellt.

Gemäß einem weiteren Erfindungsmerkmal ist ein mit der Steuerung verbundenes gesteuertes Schaltnetzwerk vorgesehen, das mit den Anschlüssen und der oder jeder Stromquelle, der oder jeder allfälliger Strommeßvorrichtung, der oder jeder Spannungsmeßvorrichtung und der Steuerung verbunden ist. Durch dieses Konstruktionsmerkmal wird ein vollautomatischer Meßablauf ermöglicht. Das gesteuerte Schaltnetzwerk kann verschiedenartig, beispielsweise durch Halbleiterbauelemente realisiert werden.

Vorteilhafterweise weist die Vorrichtung eine Schnittstelle auf, über die Meßergebnisse abgefragt, aber auch Meßparameter oder Meßprogramme in den Mikrokontroller oder Mikroprozessor eingebracht werden können.

In der nachfolgenden Beschreibung werden weitere Merkmale der Erfindung unter Bezugnahme auf die beiliegenden Zeichnungen näher beschrieben.

Dabei zeigen

Fig. 1 schematisch eine Schaltung zur standardmäßigen Messung des Schleifenwiderstands,

Fig. 2 das Schema der erfindungsgemäßen Messung des Erdungswiderstandes,

Fig. 3 das Schema der erfindungsgemäßen Messung des Netzinnenwiderstandes, und

Fig. 4 das Blockschaltbild einer Vorrichtung zur Durchführung der erfindungsgemäßen Messungen gemäß Fig. 2 und Fig. 3.

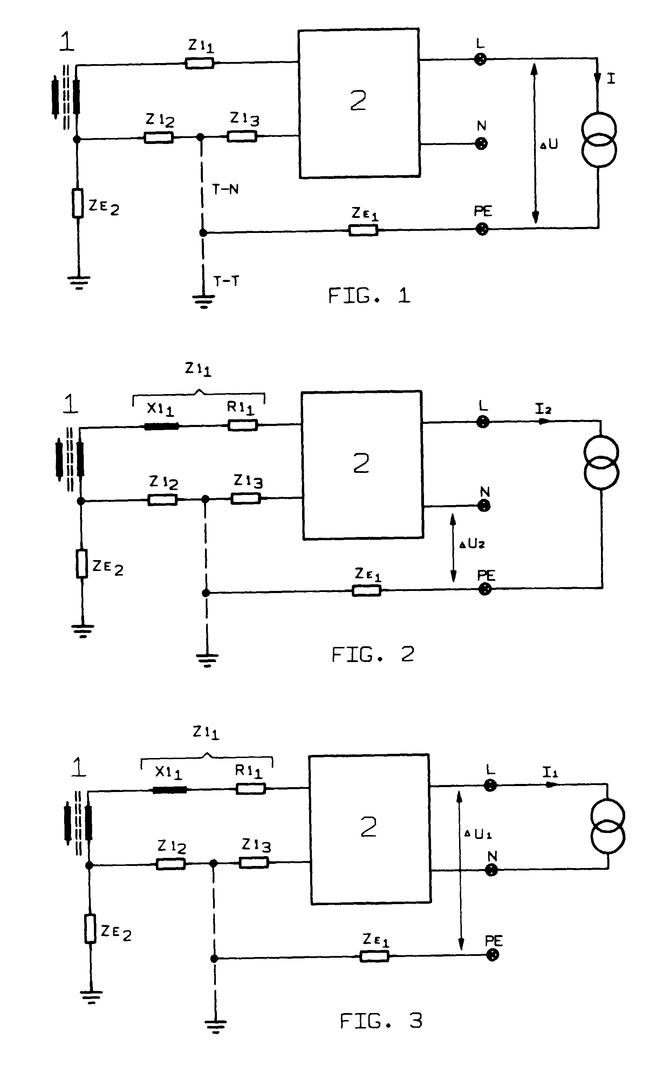

Fig. 1 zeigt schematisch ein durch einen Transformator 1 gekennzeichnetes Netz, welches in an sich bekannter Weise durch einen Fehlerstromschutzschalter 2 geschützt ist. Der Fehlerstromschutzschalter 2 mißt den in den Verbraucher hinein- und zurückfließenden Strom und unterbricht die Ausgangsspannung, wenn die beiden Ströme voneinander mehr als einen vorgegebenen Betrag abweichen. Ein solcher Fall kann beispielsweise dann auftreten, wenn Fehlerströmen über das Gehäuse des Verbrauchers gegen Erde beispielsweise durch Berührung fließen. Die Netzinnenimpedanz $Z_i$ setzt sich aus den ohm'schen und induktiven Widerständen der Zuleitungen und aus den Streuinduktivitäten des Transformators zusammen und ist im dargestellten Schaltkreis durch die drei Netzinnenwiderstände $Z_{i1}$, $Z_{i2}$ und $Z_{i3}$ charakterisiert. Darüber hinaus treten die Erdungswiderstände $Z_{E1}$ für ein T-N-Netz bzw. $(Z_{E1} + Z_{E2})$ für ein T-T-Netz auf. Bei einem T-N-Netz ist das Netz lokal beim Verbraucher nicht geerdet und der Schutzleiter mit dem Nulleiter verbunden. Bei T-T-Netzen ist das Netz lokal geerdet, daher resultiert als Erdungswiderstand die Summe aus dem Erdungswiderstandes $Z_{E1}$ der lokalen Erdung und dem Erdungswiderstand $Z_{E2}$ der Erdung des Netztransformators 1. Die Schleifenimpedanz $Z_S$ setzt sich aus der Netzinnenimpedanz $Z_i$ und dem Erdungswiderstand $Z_E$ zusammen. Es gilt also

$$Z_S = Z_{E1} + Z_i = Z_{E1} + Z_{i1} + Z_{i2} \text{ für ein T-N-Netz,}$$

bzw.

$$Z_S = (Z_{E1} + Z_{E2}) + Z_i = (Z_{E1} + Z_{E2}) + Z_{i1} \text{ für ein T-T-Netz.}$$

Zur Messung der Schleifenimpedanz $Z_S$ des Netzes wird üblicherweise durch eine im Meßgerät 3 vorhandene Stromquelle ein bestimmter Strom 1 zwischen dem Außenleiter L und dem Schutzleiter PE eingeprägt und der aufgrund dieser Belastung des Netzes resultierende Unterschied der Spannung zur Leerlaufspannung $\Delta U$ registriert. Die Schleifenimpedanz folgt daher aus $Z_s = \Delta U/I$. Anstelle eines eingeprägten Stromes kann das Netz auch mit einem Widerstand belastet werden und der resultierende Strom gemessen werden. Der Meßstrom I darf allerdings nur unter dem halben Nennstrom des vorgeschalteten Fehlerstromschutzschalters 2 liegen, da es sonst zur Auslösung des Fehlerstromschutzschalters 2 kommen würde. Aufgrund zufälliger, beispielsweise von Schaltvorgängen herrührenden Netzschwankungen schwankt auch das Meßergebnis in bestimmten Grenzen. Dieser Fehler wirkt sich umso mehr aus, je kleiner der Meßstrom I ist. Da dieser aber durch den Fehlerstromschutzschalter beschränkt ist und beispielsweise im Bereich von 15 mA (bei einem üblichen Nennstrom des FI-Schutzschalters von 30 mA) liegt, bewirken die stochastischen Netzschwankungen zu große Schwankungen des Meßergebnisses. Nicht selten liegen die durch die Netzschwankungen bewirkten Widerstandsschwankungen im Bereich von ± 10 Ohm für Schleifenwiderstände im Bereich von etwa 1 Ohm. Dementsprechend gering ist die Meßgenauigkeit bei diesen bekannten Verfahren. Die stochastischen Schwankungen könnten durch vielfache Messungen und Bildung des arithmetischen Mittelwerts reduziert werden, was allerdings auch einen erhöhten Aufwand bedeutet.

In Fig. 2 ist das Schema der erfindungsgemäßen Messung des Erdungswiderstandes als Teil der Bestimmung des Schleifenwiderstandes dargestellt. Dabei wird zwischen dem Außenleiter L und dem Schutzleiter PE ein Strom $I_2$ eingeprägt und aufgrund des Span-

nungsabfalls $\Delta U_2$ zwischen Nulleiter N und Schutzleiter PE auf den Erdungswiderstand $Z_E = Z_{E1}$ (bei T-N-Netzen) bzw. $Z_E = Z_{E1} + Z_{E2}$ (bei T-T-Netzen) rückgeschlossen. Der Strom $I_2$ muß von solcher Form und Amplitude sein (vorzugsweise kleiner als der halbe Nennfehlerstrom des Schutzschalters), sodaß dieser nicht durch den Meßstrom $I_2$ ausgelöst wird. Da bei der erfindungsgemäßen Spannungsmessung zwischen Nulleiter N und Schutzleiter PE keine Netzspannung anliegt, wirken sich Netzspannungsschwankungen nicht auf das Meßergebnis aus, wodurch die Messung auch bei kleinem Meßstrom $I_2$ zu einem genauen Meßergebnis führt. Für eine sichere Funktion des Schutzschalters 2 ist der tatsächliche Erdungswiderstand $Z_E$, dessen Ermittlung allerdings kompliziert oder praktisch unmöglich sein kann, maßgeblich. Die vom beschriebenen Verfahren ermittelte Komponente $Z_E$ des Schleifenwiderstandes $Z_S$ kann je nach Netzform davon abweichen und zwar sowohl größer als auch kleiner sein. Zur Beurteilung des Erdungswiderstandes $Z_E$ einer Anlage soll daher der Schleifenwiderstand $Z_S$, der immer größer als der tatsächliche Erdungswiderstand $Z_E$ ist, herangezogen werden. Zur Bestimmung der Schleifenimpedanz $Z_S$ kann, insbesondere bei T-T-Netzen der Erdungswiderstand $Z_E$ allein als ausreichende Näherung herangezogen werden. Zur genaueren Bestimmung wird zusätzlich in dem im folgenden beschriebenen Meßverfahren die Netzinnenimpedanz $Z_i$ ermittelt.

Gemäß Fig. 3 wird zur Bestimmung der Netzinnenimpedanz $Z_i$ zwischen dem Außenleiter L und dem Nulleiter N ein Strom $I_1$ eingeprägt, und die Spannungsdifferenz $\Delta U_1$ zwischen dem Außenleiter L und dem Schutzleiter PE zwischen unbelastetem und durch den Strom $I_1$ belasteten Fall gemessen. Der Netzinnenwiderstand $Z_i = Z_{i1} + Z_{i2}$ resultiert dann aus der Division der Spannungsdifferenz $\Delta U_1$ und des eingeprägten Stromes $I_1$. Da der zwischen dem Außenleiter L und Nulleiter N fließende Strom $I_1$ den Fehlerstromschutzschalter 2 nicht auslöst, kann dieser relativ hoch gewählt werden, wodurch die Meßgenauigkeit steigt.

Die Schleifenimpedanz $Z_S$ setzt sich aus dem nach dem Meßverfahren gemäß Fig. 2 ermittelten Erdungswiderstand $Z_E$ und dem nach dem Verfahren gemäß Fig. 3 ermittelten Netzinnenwiderstand $Z_i$ zusammen. Durch das erfindungsgemäße Verfahren wird der Einfluß von Netzspannungsschwankungen auf das Ergebnis des gemessenen Schleifenwiderstands $Z_S$ reduziert, da der Netzinnenwiderstand $Z_i$ mit hohem Strom gemessen wird, während die Messung des Erdungswiderstands $Z_E$ mit kleinem Strom, aber netzspannungsstörungsfrei ermittelt wird, sodaß insgesamt ein gut reproduzierbares, genaues Ergebnis geliefert wird, ohne daß der Schutzschalter durch die Messung auslöst.

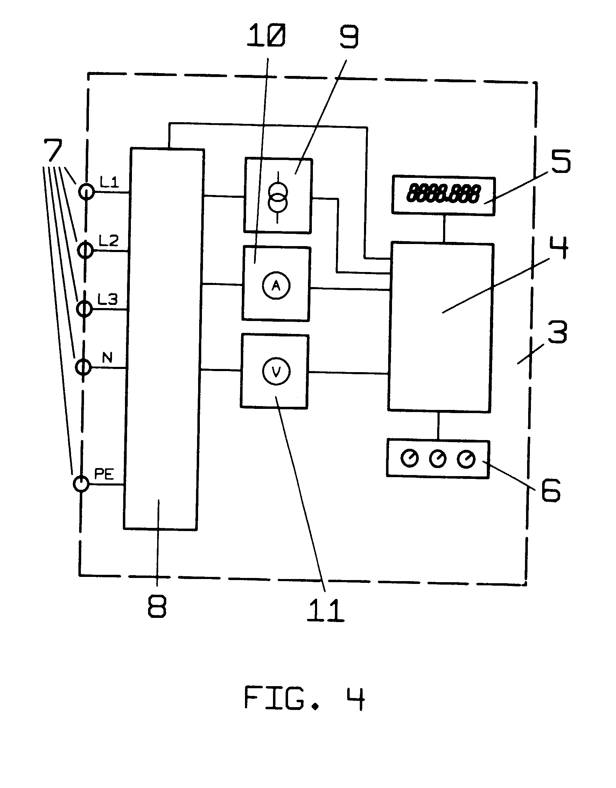

Fig. 4 zeigt ein Blockschaltbild einer Vorrichtung zur Durchführung der erfindungsgemäßen Meßverfahren gemäß Fig. 2 und Fig. 3. Die Meßvorrichtung 3 wird an das jeweilige Netz angeschlossen und in manuell gesteuerter oder automatischer Weise der Erdungswiderstand und/oder der Schleifenwiderstand ermittelt. Die Meßvorrichtung 3 weist Anschlüsse 7 zur Verbindung mit den Leitern des Netzes auf. Dies sind der Außenleiter L, Nulleiter N und Schutzleiter PE bei einem einphasigen Netz bzw. drei Außenleiter $L_1$, $L_2$, $L_3$, der Nulleiter N und der Schutzleiter PE im Fall eines Dreiphasennetzes. Hinter den Anschlüssen 7 befindet sich ein gesteuertes Schaltnetzwerk 8, welches die jeweils gewünschten Verbindungen herstellen. Die Steuerung 4, welche vorzugsweise durch einen Mikrokontroller oder Mikroprozessor gebildet wird, übernimmt die Steuerung des Meßablaufs. Durch einen Mikrokontroller oder Mikroprozessor ist das Meßverfahren sehr flexibel und leicht an die jeweiligen Einsatzfälle anpaßbar. Die Steuerung ist mit zumindest einer Stromquelle 9 zum Einprägen des oder der Meßströme, zumindest einer Strommeßvorrichtung 10 und zumindest einer Spannungsmeßvorrichtung 11 verbunden, welche ihrerseits zur richtigen Durchschaltung zu den Leitungen des Netzes mit dem gesteuerten Schaltnetzwerk 8. Zur Bedienung und Beeinflussung des Meßablaufs können Bedienungselemente 6 vorgesehen sein, welche mit der Steuerung verbunden sind. Die Meßergebnisse werden vorzugsweise auf zumindest einer Anzeige 5 dargestellt. Dabei können entweder die gemessenen Spannungsabfälle oder gleich die ausgewerteten Werte für die Widerstände bzw. Impedanzen an der Anzeige 5 angezeigt werden. Bei der Anzeige der Impedanz kann vorteilhafterweise zwischen einer Darstellung des Real- und Imaginärteils oder des Betrags und der Phase gewählt werden. Eine allfällige Spannungsversorgung der Meßvorrichtung 3 ist nicht dargestellt. Im Rahmen der Erfindung sind beliebige Änderungen der Ausführung möglich. So ist auch die Anwendung in einem Dreiphasennetz mit entsprechend drei Außenleitern $L_1$, $L_2$ und $L_3$ in gleicher Weise wie bei einem einphasigem Netz möglich.

**Patentansprüche**

1. Verfahren zur Messung des Schleifenwiderstandes in Schutzschalter-geschützten Netzen mit zumindest einem Außenleiter ($L_1$, $L_2$, $L_3$), einem Nulleiter (N) und einem Schutzleiter (PE), wobei zwischen dem oder jedem Außenleiter ($L_1$, $L_2$, $L_3$) und dem Schutzleiter (PE) ein Strom ($I_2$) eingeprägt wird, der kleiner, vorzugsweise höchstens halb so groß ist, wie der Nennstrom des Schutzschalters, dadurch gekennzeichnet,

   - daß der durch den zwischen dem oder jedem Außenleiter ($L_1$, $L_2$, $L_3$) und dem Schutzleiter (PE) eingeprägten Strom ($I_2$) hervorgerufene Spannungsabfall ($\Delta U_2$) zwischen Nulleiter (N) und Schutzleiter (PE), vorzugsweise nach der an sich bekannten Methode der Spannungsabsenkung gemessen wird,

- daß durch Division des Spannungsabfalls ($\Delta U_2$) und des eingeprägten Stromes ($I_2$) der Erdungswiderstand ($Z_E$) berechnet wird,
- daß in einem weiteren Schritt zwischen dem oder jedem Außenleiter ($L_1$, $L_2$, $L_3$) und dem Nulleiter (N) ein Strom ($I_1$) eingeprägt wird, der wesentlich größer als der Auslösestrom des Schutzschalters ist,
- daß nach dem an sich bekannten Verfahren der Spannungsabsenkung die Spannungsdifferenz ($\Delta U_1$) zwischen dem oder jedem Außenleiter ($L_1$, $L_2$, $L_3$) und Schutzleiter (PE) zwischen unbelastetem und durch den zwischen dem oder jedem Außenleiter ($L_1$, $L_2$, $L_3$) und dem Nulleiter (N) eingeprägten Strom ($I_1$) belasteten Fall gemessen wird,
- daß daraus durch Division der Spannungsdifferenz ($\Delta U_1$) und des eingeprägten Stromes ($I_1$) der Netzinnenwiderstand ($Z_i$) berechnet wird, und
- daß der Schleifenwiderstand ($Z_s$) aus der Summe des Erdungswiderstandes ($Z_E$) und des Netzinnenwiderstandes ($Z_i$) ermittelt wird.

2. Verfahren nach Anspruch 1, dadurch gekennzeichnet, daß das Netz durch einen zwischen dem oder jeden Außenleiter ($L_1$, $L_2$, $L_3$) und dem Nulleiter (N) angeordneten Widerstand belastet und der resultierende Strom ($I_1$) gemessen wird.

3. Verfahren nach Anspruch 1 oder 2, dadurch gekennzeichnet, daß das Netz durch den zwischen dem oder jeden Außenleiter ($L_1$, $L_2$, $L_3$) und dem Schutzleiter (PE) eingeprägten Strom ($I_1$) und/oder dem oder jeden Außenleiter ($L_1$, $L_2$, $L_3$) und dem Nulleiter (N) eingeprägten Strom ($I_2$) pulsförmig, halbwellenartig oder periodenweise belastet wird.

4. Vorrichtung zur Durchführung des Verfahrens nach Anspruch 1 bis 3, mit mindestens drei Anschlüssen (7) zur Verbindung mit den Leitern ($L_1$, $L_2$, $L_3$, N, PE) des zu analysierenden Netzes, einer Steuerung (4) zur Steuerung des Meßablaufs, welche beispielsweise durch einen Mikrokontroller oder Mikroprozessor gebildet ist, zumindest einer Stromquelle (9), allenfalls einer Strommeßvorrichtung (10), zumindest einer Spannungsmeßvorrichtung (11), zumindest einer Anzeige (5) und allenfalls Bedienungselementen (6), wobei die oder jede Stromquelle (9), die oder jede allfällige Strommeßvorrichtung (10), die oder jede Spannungsmeßvorrichtung (11), die oder jede Anzeige (5) und die allfälligen Bedienungselemente (6) mit der Steuerung (4) verbunden sind, dadurch gekennzeichnet, daß mit der oder den Stromquelle(n) (9) ein Strom ($I_2$) zwischen dem oder jedem Außenleiter ($L_1$, $L_2$, $L_3$) und dem Schutzleiter (PE) einprägbar und mit der oder den Spannungsmeßvorrichtung(en) (11) der resultierende Spannungsabfall ($\Delta U_2$) zwischen Nulleiter (N) und Schutzleiter (PE) erfaßbar, und daß mit der oder den Stromquelle(n) (9) ein Strom ($I_1$) zwischen dem oder jedem Außenleiter ($L_1$, $L_2$, $L_3$) und dem Nulleiter (N) einprägbar und mit der oder den Spannungsmeßvorrichtung(en) (11) der resultierende Spannungsabfall ($\Delta U_1$) zwischen dem oder jedem Außenleiter ($L_1$, $L_2$, $L_3$) und dem Schutzleiter (PE) erfaßbar ist, und daß die resultierenden Meßwerte an der oder den Anzeige(n) (5) darstellbar sind.

5. Vorrichtung nach Anspruch 4, gekennzeichnet durch ein mit der Steuerung (4) verbundenes gesteuertes Schaltnetzwerk (8), das mit den Anschlüssen (7) und der oder jeder Stromquelle (9), der oder jeder allfälliger Strommeßvorrichtung (10), der oder jeder Spannungsmeßvorrichtung (11) und der Steuerung (4) verbunden ist.

6. Vorrichtung nach Anspruch 4 oder 5, dadurch gekennzeichnet, daß die Vorrichtung zumindest eine Schnittstelle aufweist.

FIG. 1

FIG. 2

FIG. 3

FIG. 4